# EUROPÄISCHE PATENTSCHRIFT

(11) **EP 0 542 210 B1**
(45) Veröffentlichungstag und Bekanntmachung des Hinweises auf die Patenterteilung: **04.10.1995**
(21) Anmeldenummer: 92119239.9
(22) Anmeldetag: 11.11.1992
(51) Int. Cl.: G02B 6/12, C23C 16/50

(54) **Verfahren zur Herstellung eines optischen Dünnschicht-Wellenleiters aus TiO2**
Method of making an optical thin film waveguide of TiO2
Méthode de fabrication d'un guide d'ondes couche mince en TiO2

(30) Priorität: 15.11.1991 DE 4137606
(43) Veröffentlichungstag der Anmeldung: 19.05.1993
(73) Patentinhaber: Schott Glaswerke, 55122 Mainz (DE); CARL-ZEISS-STIFTUNG, 55122 Mainz (DE)
(72) Erfinder: Heming, Martin, Dr., W-6501 Saulheim (DE); Hochhaus, Roland, W-6500 Mainz 21 (DE); Otto, Jürgen, Dr., W-6500 Mainz (DE); Paquet, Volker, W-6500 Mainz 21 (DE)

(56) Entgegenhaltungen:
- EP-A- 0 207 767
- WO-A-90/02964
- GB-A- 2 199 157
- PATENT ABSTRACTS OF JAPAN vol. 15, no. 140 (P-1188) 9. April 1991 & JP-A-3018803
- PATENT ABSTRACTS OF JAPAN vol. 8, no. 117 (P-277)(1554) 31. Mai 1984 & JP-A-59024807

## Beschreibung

Gegenstand der Erfindung ist ein Verfahren zur Herstellung eines optischen Dünnschicht-Wellenleiters aus TiO₂ mit einer Dämpfung von < 5 dB/cm auf einem planaren anorganischen Substrat.

Dünnfilm-Wellenleiter auf planaren anorganischen Substraten sind an sich bekannt. So wird in Sov. J. Opt. Technol. 54 (1), Jan. 1987, Seite 22 bis 24 ein Verfahren zur Herstellung der Wellenleiter durch Sputtern beschrieben. Allerdings besitzen die dort beschriebenen Wellenleiter eine sehr hohe Dämpfung von bis zu 8 dB/cm, was in der Praxis unbefriedigend ist. Ein ähnliches Verfahren ist in JP-OS 3-28832 vom 7. Febr. 1991 beschrieben. Weitere Verfahren zur Herstellung von Wellenleitern, angefangen vom Dünnschicht-Aufdampfverfahren über Sputtern, Tauch- und Schleuderverfahren bis hin zu CVD-, Diffussions-, Ionenaustausch- oder Ionenimplantitation-Verfahren sind in Hutcheson L. D.: Integrated opt. circuits and components, M. Dekker Inc., New York and Basel, 1987, Seite 57-69 beschrieben.

Obwohl TiO₂ aufgrund seiner physikalischen und chemischen Eigenschaften als Material für Dünnschicht-Wellenleiter sehr geeignet wäre, weil es eine sehr hohe Brechzahl, sowie eine gute chemische Beständigkeit hat und sehr hart ist, ist in der Literatur kein Verfahren zur Herstellung eines verlustarmen TiO₂-Dünnschicht-Wellenleiters bekannt, denn TiO₂ neigt bei seiner Herstellung sehr stark zur Kristallisation. An den Kristallflächen findet eine Streuung statt, die eine starke Dämpfung hervorruft.

Ein Verfahren zur Herstellung eines optischen Dünnschicht-Wellenleiters aus TiO₂ durch Sputtern ist aus JP-OS-59 024 807 bekannt.

Es besteht daher die Aufgabe, ein Verfahren zur Herstellung eines optischen Dünnschicht-Wellenleiters aus TiO₂ auf einem planaren anorganischen Substrat zu finden, mit dem diese Wellenleiter mit einer Dämpfung von < 5 dB/cm hergestellt werden können.

Diese Aufgabe wird durch das in Patentanspruch 1 beschriebene Verfahren gelöst.

Das Mikrowellen-Plasma-CVD-Verfahren sowie das Mikrowellen-Plasmaimpuls-CVD-Verfahren an sich sind der Fachwelt wohl bekannt und z.B. beschrieben in US-PS 3 114 652, US-PS 4 492 620 oder US-PS 5 030 574.

Die Mikrowellen werden in einem üblichen Mikrowellen-Generator mit einer Frequenz von 300 MHz bis 10 GHz erzeugt. Vorzugsweise kommen Frequenzen zwischen 2 und 3 GHz zur Anwendung, weil in diesem Bereich preiswerte Generatoren aus laufender Serienproduktion erhältlich sind. Die Leistungen für das Mikrowellenplasma liegen zwischen 800 W und etwa 10 KW. Die Wellenleiter werden mit einer Schichtdicke von 0,1 bis 0,3 µm erzeugt. Besonders hochwertige Schichten lassen sich erreichen, wenn ein Mikrowellen-Plasmaimpuls-CVD-Verfahren zur Anwendung kommt. Bei diesem Verfahren werden die Mikrowellen getaktet erzeugt. Die Pulsdauer für die Mikrowellenimpulse liegt üblicherweise zwischen 0,5 und 2 ms, während die Impulspause üblicherweise zwischen 10 und 100 ms liegt. Bei Anwendung des Impuls-Verfahren kann die Impulsleistung entsprechend dem Takt-Verhältnis gesteigert werden. Diese Leistung wird nach oben allerdings durch die elektrischen Daten des Magnetrons eingeschränkt. Im allgemeinen wird das 10-fache der mittleren Leistung (CW-Leistung) nicht überschritten. Als Ausgangssubstanz für die TiO₂-Schicht kommen alle Ti-Verbindungen, die eine ausreichende Flüchtigkeit haben, in Betracht, z.B. Titanhalogenide wie TiCl₄, aber auch titanorganische Verbindungen wie Titanester oder Titanacetylacetonat. Es ist ferner mitunter von Vorteil, wenn nicht eine reine TiO₂-Schicht erzeugt wird, sondern wenn die Schicht, z.B. zur Unterdrückung der Kristallisation geringe Mengen an weiteren Oxiden, z.B. ZnO, Nd₂O₅, Ta₂O_{5,} ZrO₂, HfO₂ oder SiO₂ enthält. Diese verschiedenen Oxide sind jedoch im allgemeinen nur in Mengen von insgesamt bis zu 5% in der TiO₂-Schicht enthalten.

Als anorganische Substrate finden in erster Linie Platten aus Glas, mitunter auch aus Einkristallen, z. B. Saphir, Verwendung.

Es konnte gefunden werden, daß die mit dem Mikrowellen-Plasma-CVD-Verfahren erzeugten TiO₂-Schichten eine Dämpfung von < 5 dB/cm (für TE₀₁-Mode) besitzen. Die Substrattemperatur liegt während der Beschichtung zwischen ca. 40°C und 300°C, wobei eine Temperatur ab 60°C bevorzugt wird, da die erzeugten TiO₂-Schichten dann eine niedrigere Dämpfung besitzen. Bereits Substrattemperaturen von 60°C reichen aus, um wellenleitende TiO₂-Schichten mit einer Dämpfung von < 3 dB/cm zu erzeugen. Diese Schichten weisen darüber hinaus eine hohe Packungsdichte von annähernd 1 (= 100 % der theor. Dichte) auf und besitzen keine Säulenstruktur, sind vollständig durchoxidiert und besitzen eine Brechzahl, die praktisch der des reinen massiven TiO₂ entspricht.

Es wird vermutet, daß die besondere Qualität der nach dem Mikrowellen-Plasma-CVD-Verfahren erzeugten TiO₂-Wellenleiterschichten darauf beruht, daß im Parameterfeld der Beschichtung die Elektronentemperatur nur wenige eV beträgt und daß das self-bias-Potential zwischen Plasma und Substrat mit < 20 Volt verhältnismäßig gering ist. Die Oberfläche des Substrats wird deshalb nicht durch das Plasma strahlengeschädigt. Die ursprünglichen Oberflächeneigenschaften des Substrats sowie die Eigenschaften der entstehenden Schicht werden dadurch nicht beeinträchtigt.

Es ist weiterhin von Vorteil, wenn das Substrat vor der Beschichtung mit einem sauerstoffhaltigen Mikrowellenplasma in Kontakt gebracht wird, das keine Beschichtungssubstanzen enthält und dadurch lediglich an der Oberfläche durch den angeregten Sauerstoff gereinigt wird.

### Beispiel:

Herstellung eines Wellenleiters aus TiO₂ auf einer Quarzglasplatte. Die Beschichtung wird in einer üblichen Mikrowellen-PI-CVD-Anlage durchgeführt, wie sie z.B. in Otto J. et al: SPIE vol. 1323/1990, Seiten 39-49 beschrieben ist. Es handelt sich hierbei um einen Parallelplattenreaktor mit Gasdusche. Die Reaktionsgase werden durch die Gasdusche in den Reaktionsraum geleitet. Das Substrat liegt auf einer für Mikrowellentransparenten dielektrischen Grundplatten. Die Prozeßabgase werden radial abgepumpt. Die Frequenz des Mikrowellengenerators beträgt 2,45 GHz. Zunächst wurde das Substrat durch eine Plasmavorbehandlung von Verunreinigungen auf der Substratoberfläche befreit. Zu diesem Zweck wurde Sauerstoff unter einem Druck von 0,8 mbar in einer Menge von 100 ml/min in den Reaktionsraum eingeleitet. Statt Sauerstoff können auch Stickstoff, Argon oder Gemische der drei Gase Verwendung finden. Das Plasma wurde mittels eines Mikrowellengenerators mit einer Frequenz von 2,45 GHz erzeugt. Das Plasma wurde getaktet erzeugt, wobei der Impuls für die Brenndauer des Plasma 1 ms betrug, während die Impulspause, während der das Plasma abgeschaltet war, 90 ms betrug. Abhängig vom Verschmutzungsgrad der Substratoberfläche und der Dicke der an die Oberfläche adsorptiv gebundenen Wasserhaut war die Plasmavorbehandlung nach 5-300 Sek. beendet. Danach erfolgte die Beschichtung mit TiO₂ unter folgenden Bedingungen: Druck: 0,8 mbar; Massenfluß TiCl₄: 4 ml/min; Massenfluß O2: 100 ml/min; Impulsdauer: 1 ms; Impulspause: 90 ms; Substrattemperatur: 60°C. Unter diesen Bedingungen ergab sich eine Beschichtungsrate von 40nm/min. Nachdem eine Schichtdicke von 140nm erreicht war, wurde der Versuch beendet. Statt einer Substrattemperatur von 60°C können Substrattemperaturen bis 300°C zur Anwendung kommen. In diesem Bereich ergeben sich besonders gute Schichten. Durch herkömmliche Ätzverfahren, z. B. durch lonenstrahlätzen, können in der Oberfläche des Substrates Wellenleiterbahnen beliebiger optischer Geometrie erzeugt werden. Die Verluste in dem Wellenleiter für TE₀₁-Wellen liegen bei 2,5 dB/cm.

## Patentansprüche

1. Verfahren zur Herstellung eines optischen Dünnschicht-Wellenleiters aus TiO₂ auf einem planaren anorganischen Substrat,
**dadurch gekennzeichnet,**
daß der Dünnschichtwellenleiter mittels eines Mikrowellen-Plasma-CVD-Verfahrens (PCVD) erzeugt wird, und daß der Wellenleiter eine Dämpfung von < 5 dB/cm aufweist.

2. Verfahren nach Anspruch 1, **dadurch gekennzeichnet,**
daß der Dünnschichtwellenleiter mittels eines Mikrowellen-Plasmaimpuls-CVD-Verfahrens (PICVD) erzeugt wird.

3. Verfahren nach Anspruch 1 oder 2,
**dadurch gekennzeichnet,**
daß Mikrowellen im Frequenzbereich von 0,3 bis 10 GHz verwendet werden.

4. Verfahren nach wenigstens einem der Ansprüche 1 bis 3,
**dadurch gekennzeichnet,**
daß die Oberfläche des anorganischen Substrats vor der Beschichtung mit TiO₂ durch Behandeln mit einem O₂-haltigen Mikrowellenplasma gereinigt wird.

## Claims

1. A process for manufacturing an optical thin-layer waveguide of TiO₂ on a planar inorganic substrate, characterized in that the thin-layer waveguide is produced by means of a microwave plasma CVD process (PCVD), and in that the waveguide has an attenuation of < 5 dB/cm.

2. A process according to Claim 1, characterized in that the thin-layer waveguide is produced by means of a microwave plasma pulse CVD process (PICVD).

3. A process according to Claim 1 or 2, characterized in that microwaves in the frequency range from 0.3 to 10 GHz are used.

4. A process according to at least one of Claims 1 to 3, characterized in that the surface of the inorganic substrate is cleaned by treatment with a microwave plasma containing O₂ before being coated with TiO₂.

## Revendications

1. Procédé de fabrication d'un guide d'ondes optiques en couche s minces en TiO₂ sur un substrat planaire inorganique, caractérisé par le fait que l'on produit le guide d'ondes en couches minces par un procédé CVD assisté par plasma hyperfréquences (PCVD) et par le fait que le guide d'ondes présente un affaiblissement < 5 dB/cm.

2. Procédé selon la revendication 1, caractérisé par le fait que 1 l'on produit le guide d'ondes en couches minces par un procédé CVD assisté par impulsions de plasma hyperfréquences (PICVD).

3. Procédé selon la revendication 1 ou la revendication 2, caractérisé par le fait que l'on utilise des ondes hyperfréquences comprises dans la plage allant de 0,3 à 10 GHz.

4. Procédé selon au moins une des revendications 1 à 3, caractérisé par le fait qu'avant son revêtement avec du TiO₂, on nettoie la surface du substrat par traitement avec un plasma hyperfréquences chargé en O₂.
